(19) Europäisches Patentamt
European Patent Office
Office européen des brevets

(11) **EP 4 715 657 A1**

(12) **EUROPEAN PATENT APPLICATION**

(43) Date of publication:
**25.03.2026 Bulletin 2026/13**

(21) Application number: **24306555.4**

(22) Date of filing: **20.09.2024**

(51) International Patent Classification (IPC):
**G06F 30/17** (2020.01)    **G06F 30/27** (2020.01)
**G06N 3/045** (2023.01)    **G06N 3/08** (2023.01)

(52) Cooperative Patent Classification (CPC):
**G06F 30/17; G06F 30/27; G06N 3/045; G06N 3/08**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Dassault Systèmes**
**78140 Vélizy-Villacoublay (FR)**

(72) Inventors:
• **Zhao, Tong**
**78140 Vélizy-Villacoublay (FR)**
• **Rejeb Sfar, Asma**
**78140 Vélizy-Villacoublay (FR)**
• **Ammari, Sâad**
**78140 Vélizy-Villacoublay (FR)**

(74) Representative: **Bandpay & Greuter**
**11 rue Christophe Colomb**
**75008 Paris (FR)**

(54) **MACHINE-LEARNING FOR ASSEMBLING MECHANICAL PARTS**

(57) The disclosure notably relates to a computer-implemented method of machine-learning for assembling mechanical parts, based on a mating score and a mating axis. The method comprises providing a dataset of pairs of B-Reps, each pair comprising at least one B-Rep representing an assembly of mechanical parts, being labelled with mating compatibility data and, if the B-Reps of the pair are compatible according to the mating compatibility data, mating axis compatibility data. The method also comprises training a neural network based on the dataset, configured for taking as input a pair of B-Reps. The neural network also outputs a mating score of a pair of single embeddings, each single embedding representing a B-Rep, the mating score representing a score of mating compatibility between the mechanical parts represented by the pair, and if the B-Reps are compatible according to the mating score, data defining a mating axis.

**Description**

**TECHNICAL FIELD**

The disclosure relates to the field of computer programs and systems, and more specifically to methods, system and program of machine-learning for assembling mechanical parts.

**BACKGROUND**

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Within this context, there is still a need for an improved solution for assembling mechanical parts.

**SUMMARY**

It is therefore provided a computer-implemented method of machine-learning for assembling mechanical parts, based on a mating score and a mating axis. The method comprises providing a dataset of pairs of Boundary Representations (B-Reps) representing mechanical parts. Each pair comprises at least one B-Rep representing an assembly of mechanical parts. Each pair is labelled with mating compatibility data. If the B-Reps of the pair are compatible according to the mating compatibility data, the pair is labelled with mating axis compatibility data. The mating compatibility data represents an extent of mating compatibility between the mechanical parts represented by the pair. The mating axis compatibility data represents an extent of compatibility between the mechanical parts represented by the pair along a mating axis defined by a pair of B-Rep entities of the B-Reps of the pair. The method also comprises training a neural network based on the dataset. The neural network is configured for taking as input a pair of B-Reps each representing a mechanical part or an assembly of mechanical parts. The neural network is also configured for outputting a mating score of a pair of single embeddings. Each single embedding represents a B-Rep of the pair. The mating score represents a score of mating compatibility between the mechanical parts represented by the pair. The neural network is also configured for outputting, if the B-Reps of the pair are compatible according to the mating score, data defining a mating axis.

The method may comprise one or more of the following:

- the neural network comprises:

  ○ an embedding network configured to be applied to a respective pair of B-Reps and to output a single embedding for each B-Rep of the pair;
  ○ a mating compatibility score network configured to take as input a concatenation of the pair of single embeddings and to output the mating score; and
  ○ an axis network configured to be applied to a respective pair of B-Reps and to output data defining a mating axis of the pair;

- the embedding network comprises a Siamese encoder configured to take as input the pair of B-Reps, the output of the Siamese encoder being passed as input to the mating compatibility score network and the axis network;
- the neural network comprises a pooling module applied on the output of the Siamese encoder; and/or
- the embedding network, the mating compatibility score network and the axis network are trained simultaneously using a loss, the loss penalizing, for each pair of B-Reps of the dataset:

◦ a disparity between the mating compatibility data of the pair of B-Reps and the mating score outputted by the neural network for the pair of B-Reps; and/or
◦ a disparity between the mating axis compatibility data of the pair of B-Reps and the data defining the mating axis outputted by the neural network for the pair.

It is further provided a neural network trainable according to the method.

It is further provided a method of use of the neural network. The method of use comprises obtaining a set of B-Reps, each B-Rep being associated with a single embedding obtained by applying the neural network to the B-Rep. The method of use also comprises determining an assembly of parts based on the set, by applying iteratively the neural network to a pair comprising a B-Rep of the set and an assembly resulting from the previous iteration.

The method of use may comprise one or more of the following:

- the determining is further based on the data defining a mating axis outputted by the neural network;
- the method of use further comprises applying an optimization to the assembly, the optimization fixing the degrees of freedom between the parts of the assembly;
- the iterations stop upon reaching a predetermined number of parts and/or all possible compatible parts of the set have been explored;
- the iterations start by the user selecting a B-Rep of the set or the system automatically selecting a B-Rep of the set based on a predetermined criterion; and/or
- the method of use further comprises computing the embeddings of the B-Reps of the set by applying the neural network.

It is further provided a computer program comprising instructions which, when the program is executed by a computer, cause the computer to carry out the method and/or the method of use.

It is further provided a computer readable storage medium having recorded thereon the computer program and/or the neural network.

It is further provided a system comprising a processor coupled to a memory, the memory having recorded thereon the computer program and/or the neural network.

It is further provided a device comprising a data storage medium having recorded thereon the computer program and/or the neural network.

The device may form or serve as a non-transitory computer-readable medium, for example on a SaaS (Software as a service) or another server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

## BRIEF DESCRIPTION OF THE DRAWINGS

Non-limiting examples will now be described in reference to the accompanying drawings, where:

- FIG. 1 shows a flowchart of an example of the method;
- FIG. 2 shows an example of the system; and
- FIG.s 3 to 6 illustrate the method.

## DETAILED DESCRIPTION

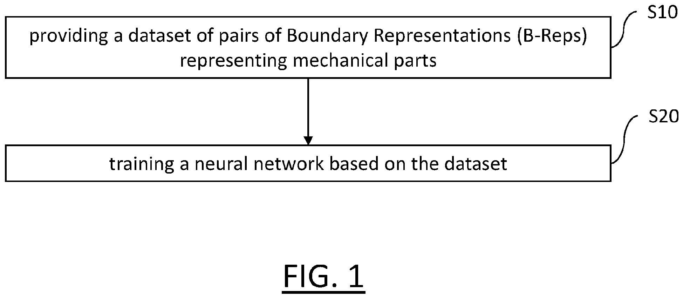

With reference to the flowchart of FIG. 1, it is proposed a computer-implemented method (also called "training method") of machine-learning for assembling mechanical parts. The assembling is based on a mating score and a mating axis. The method comprises providing S10 a dataset of pairs of Boundary Representations (B-Reps) representing mechanical parts. Each pair comprises at least one B-Rep representing an assembly of mechanical parts. Each pair is labelled with mating compatibility data. If the B-Reps of the pair are compatible according to the mating compatibility data, the pair is also labelled with mating axis compatibility data. The mating compatibility data represents an extent of mating compatibility between the mechanical parts represented by the pair. The mating axis compatibility data represents an extent of compatibility between the mechanical parts represented by the pair along a mating axis. The mating axis is defined by a pair of B-Rep entities of the B-Reps of the pair. The method also comprises training S20 a neural network based on the dataset. The neural network is configured for taking as input a pair of B-Reps. Each B-Rep of the pair represents a mechanical part or an assembly of mechanical parts. The neural network is also configured for outputting a mating score of a pair of single embeddings. Each single embedding represents a B-Rep of the pair. The mating score represents a score of mating compatibility between the mechanical parts represented by the pair. The neural network is also configured for outputting, if the B-Reps of the pair are compatible according to the mating score, data defining a mating axis.

Such a method forms an improved solution of machine-learning for assembling mechanical parts. Indeed, the neural network is configured to (i.e., trained to) output the score of mating compatibility between the mechanical parts represented by the pair and the data defining the mating axis. As the mating score represents a score of mating compatibility between the mechanical parts represented by the pair, the neural network is trained to determine the extent by which the mechanical parts represented by the pair of B-Reps may be assembled together. Moreover, concomitantly to the mating score, the data defining the mating axis represents the extent of compatibility between the mechanical parts represented by the pair along a mating axis, the mating axis being defined by a pair of B-Rep entities of the B-Reps of the pair. Thus, the neural network is trained to determine the extent by which the mechanical parts represented by the pair are aligned along the mating axis defined by the pair. In other words, not only does the neural network predict whether two B-Reps represent parts which can be assembled/mated, but, in case the method predicts the mating compatibility (e.g., as a positive result or a result indicating mating compatibility), the neural network further predicts the mating axis along which the parts can be assembled.

The methods and the neural network thus form solutions to assist a designer for assembling pairs of B-Reps of mechanical parts to be mated during a design phase of the corresponding assembly of the mechanical parts. The method thus enables the designer to explore multiple possible assemblies given a set of CAD parts and/or sub-assemblies prior for assembling the mechanical parts in the real world.

The trained neural network may thereby be used for assembling mechanical parts based on the mating score and the data defining the mating axis. In other words, the assembly in the real world of the mechanical parts may be performed by taking into account concomitantly the mating score and the mating axis as criteria. For example, the method may obtain a B-Rep representing the assembly of the B-Reps of the pair. The assembly thus represents the topological and geometrical constraints of the B-Reps of the pair while respecting the alignment in which the B-Reps should be assembled. Thus, the obtained B-Rep represents a mechanical assembly that can be efficiently manufactured in the real-world (and thus an assembly that a CAD user is likely to design).

It is further provided a neural network trainable according to the method (for example having been trained according to the training method), that is, a computer-implemented neural network data structure having the weights of a neural network trained by the method. In other words, the weights of the neural network may be definitely set (i.e., without any further post-processing of such weights) after performing the training by the method.

It is further provided a method of use of the neural network (that is, after having been trained according to the method). The method of use comprises obtaining a set of B-Reps. The set of B-Reps may be obtained from a non-volatile storage, for example from a database. This set may represent a catalog of parts to be assembled (at least for a subset of them) into an assembly to form a mechanical part. Each B-Rep is associated with a single embedding obtained by applying the neural network to the B-Rep (e.g. at an initial stage).

The method of use also comprises determining an assembly of parts based on the set. In other words, the method of use determines an assembly of at least a subset of the parts of the set. The method of use applies for that iteratively the neural network to a pair comprising a B-Rep of the set and an assembly resulting from the previous iteration. As discussed hereinbelow, the determining of the assembly of parts based on the set may be further based (if the B-Reps of the pair are compatible according to the mating score) on the data defining a mating axis outputted by the neural network. In other words, if the B-Reps of the pair are compatible according to the mating score, e.g., when the mating score is above a predetermined threshold, the assembly also comprises taking into account the mating axis output by the neural network. The iterations may start by the user selecting a B-Rep of the set. Alternatively, the system may automatically select (e.g., randomly) a B-Rep of the set based on a predetermined criterion. The iterations may stop upon reaching, a predetermined number of parts and/or all possible compatible parts of the set have been explored. In other words, the method may stop the iterations when determining that the predetermined number of parts to be assembled has been reached (for example, two or more parts of the set of B-Reps) or all possible compatible parts of the set have been explored (for example, all of the parts of the set of B-Reps have been selected so that, the mating score satisfies a predetermined threshold when assembled over the mating axis defined by the data).

For example, the method of use may comprise selecting an initial part from the set, e.g., the part containing the most B-Rep entities. Alternatively, the method of use may comprise selecting the initial part via a user input. In a first iteration, the method of use may comprise computing all the mating scores between all the possible pairs of B-Reps of the set. This is done by applying the neural network to all possible pairs. Alternatively, this application of the neural network may be done at an earlier initial stage. Alternatively, the method may compute these scores only for some pairs, i.e. by a priori excluding pairs known not to be compatible. The first iteration may then optionally comprise ranking the one or more B-Reps, e.g., in decreasing order of the mating scores that they have with the initial B-Rep, thereby prioritizing retrieved B-Reps that are more relevant to be mated with the initial B-rep. The first iteration may then comprise selecting the B-rep having the largest mating score with the initial B-Rep, or selecting (e.g. randomly or by the user) one of the K B-Reps having the largest mating scores with the initial B-Rep, K being a predefined integer number.

The first iteration also comprises assembling the initial part with the selected B-Rep based on the data defining the mating axis. This includes applying the neural network to find the mating axis and assembling the B-Reps along this axis (by any suitable CAD software assembling function/method).

In a second iteration, the method of use may proceed similarly to the first iteration: selecting the B-Rep having the largest mating score (or one of the K B-Reps having the highest mating scores) with the assembly resulting from the first iteration among the remaining B-Rep of the set (i.e. the B-Reps not selected at the first iteration). This may comprise applying the neural network to the possible pairs consisting of the assembly and each other remaining B-Reps to find their mating scores and performing the selection according to these mating scores as explained above. Alternatively, this may comprise selecting the remaining B-Rep in the set (or one of the remaining B-Reps as discussed above) which has the largest mating score with one of the B-Reps already forming the assembly, according to their already computed mating scores.

The second iteration also comprises assembling the assembly of the previous iteration with the selected B-Rep based on the data defining the mating axis of the pair consisting of the assembly and the selected B-Rep. This may include applying the neural network to this pair, or to the pair made of the selected B-Rep and said one of the B-Reps already forming the assembly, to find the axis.

The method of use may continue the iterations until there is no other B-Rep that is compatible according to the mating score, or if the maximum number of B-Reps of the set is attained.

In alternative examples, applying iteratively the neural network may comprise:
In a first iteration, selecting a pair of B-Reps from the set. Selecting the pair may be performed randomly and/or via user action, e.g., at least one B-Rep may be selected via user action and the other one may be selected at random from the set, or both B-Reps may be selected at random from the set. The first iteration also comprises applying the neural network to the pair of B-Reps and output a mating score. If the B-Reps of the pair are compatible according to the mating score (e.g., the mating score is above a predetermined threshold), the neural network also outputs data defining the mating axis. The first iteration also comprises assembling the pair of B-Reps. If the B-Reps of the pair are not compatible according to the mating score (e.g., the mating score is below a predetermined threshold), the first iteration may comprise selecting another pair of B-Reps. For example, if one B-Rep of the pair is selected via user action, the first iteration may select another B-Rep randomly and repeat the steps above.

In a second iteration, the method may select the pair comprising the assembly resulting from the first iteration (i.e., the previous iteration) and another B-Rep selected (e.g., randomly) from the set. The second iteration also comprises applying the neural network to the pair of B-Reps and outputting a mating score. If the B-Reps of the pair are compatible according to the mating score (e.g., the mating score is above a predetermined threshold), the neural network also outputs data defining the mating axis. The second iteration also comprises assembling the pair of B-Reps.

The method may continue to perform the iterations until reaching a stopping criterion. For example, the iterations may be performed until no B-Rep having a mating score above the predetermined threshold exists in the set, or until reaching a predetermined number of iterations. The method may comprise keeping track of the order in which the pieces are assembled during the iterations.

The method of use, in any of the above examples, ensures that the resulting assembly can be effectively mated along the various mating axes defined by the data. The resulting assembly has as a result, for example, an improved stiffness because mating is done on the best possible axes and between the most compatible individual parts.

The method of use is data driven, as the method of use leverages from the dataset on which the neural network has been trained to obtain the assembly. Moreover, as the method of use applies iteratively the neural network, the method allows for a fast generation of assemblies of mechanical parts stemming from the set of 3D parts. Indeed, the neural network enables the method of use to create new assemblies (having a plurality of parts assembled together) without requiring knowing a final assembly state in advance. Hence, the assembly manufactured in the real world may be completely new all while retaining strong mechanical properties when assembled.

The method of use may further comprise applying an optimization to the assembly. The optimization may comprise fixing the degrees of freedom between the parts of the assembly represented by the B-Reps. The optimization may discourage that the assembly includes disconnected parts or mis-oriented parts, thereby fixing the degrees of freedom. The optimization may include an objective function that fixes the degrees of freedom according to given constraints or physical criteria, for example how two parts should be oriented one with respect to the other or how these may be positioned so as to be assembled. The optimization thus encourages that the parts assembled along the mating axis of the B-Rep entities are totally constraint so as to have only one connected assembly.

It is further provided a process comprising performing the method and/or the method of use. Performing the training method may also be called an "offline stage", and performing the method of use may be called "online stage". The offline stage and the online stage may be performed by different systems, different entities or at different places.

The training method or the method of use may further comprise computing the embeddings of the B-Reps of the set by applying the neural network. In other words, the method may compute the embeddings at the offline stage or the method of use may compute the embeddings at the online stage. Computing the embeddings at the offline stage may comprise applying the neural network to the pair of B-Reps, outputting respective embeddings and storing the pair of B-Reps in association with the respective embeddings.

It is further provided a manufacturing process for manufacturing a physical product corresponding to the assembly of mechanical parts. The manufacturing process may comprise obtaining the trained neural network, for example by executing the method. The process may execute the method of use on the set to determine an assembly of parts. For example, the method of use may start from an initial part (e.g., provided by a user and/or a designer) and obtain an assembly as recited above. Optionally, the manufacturing process may comprise applying the previously discussed optimization to the assembly. The optimization fixes the degrees of freedom between the parts of the assembly represented by the B-Reps. In other words, the optimization encourages that the parts of the assembly are totally constrained. This allows to improve a desired physical property, for example stiffness, by using the stiffness as the optimization objective. The manufacturing process may also comprise outputting a B-Rep representing the assembly of parts resulting from the determination. The manufacturing process may also comprise using the obtained B-Rep for manufacturing the physical product.

Using the output B-Rep for manufacturing the assembly of parts designates any real-world action or series of action that is/are involved in/participate to the manufacturing of the assembly of parts represented by the obtained B-Rep. Using the obtained B-Rep for manufacturing the assembly of parts may for example comprise the following steps:

- editing the obtained B-Rep in view of manufacturing;
- performing simulation(s) based on the obtained B-Rep and/or a corresponding feature tree, such as simulations for validation of mechanical use and/or manufacturing properties and/or constraints (e.g., structural simulations, thermodynamics simulation, aerodynamic simulations);
- optionally, editing the obtained B-Rep (or feature tree thereof) based on the results of the simulation(s) and re-applying the optimization to the result of the editing;
- optionally (i.e. depending on the manufacturing process used, the production of the mechanical product may or may not comprise this step), (e.g., automatically) determining a manufacturing file/CAM file based on the (e.g., edited) B-Rep (or feature tree thereof), for production/manufacturing of the manufacturing product, the manufacturing file optionally comprising a list of the parts composing the assembly (optionally, ordered as these have been found during the iterations when executing the method of use) and information of the mating axis data;
- sending the obtained B-Rep (e.g. in the form of a CAD file) and/or the manufacturing file/CAM file to a factory; and/or
- (e.g., automatically) producing/manufacturing, based on the determined manufacturing file/CAM file or on the B-Rep, the assembly of parts originally represented by the obtained B-Rep. This may include feeding (e.g., automatically) the manufacturing file/CAM file and/or the CAD file to the machine(s) performing the manufacturing process.

This last step of production/manufacturing may be referred to as the manufacturing step or production step. This step manufactures/fabricates the assembly of parts based on the CAD model thereof (e.g. the B-Rep) and/or the CAM file, e.g., upon the CAD model and/or CAD file being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps.

The manufacturing process thus leverages from the method for an improved real-world production, as the method allows for a fast generation of new assemblies based on the obtained respective pair of B-Reps. The assembly of parts that results from assembling these mechanical parts exhibits improved physical performances, and notably improved mating strength. Indeed, as the manufacturing is based on a file that comprises the parts and the mating axis, the manufactured assembly is made of mechanical parts identified as being the most suitable for mating along the mating axis.

The methods of this disclosure are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction. The level of user-computer interaction required may depend on the level of automatism foreseen and put in balance with the need to implement user's wishes. In examples, this level may be user-defined and/or predefined.

A typical example of computer-implementation of the methods of the present disclosure is to perform the method with a system adapted for this purpose. The system may comprise a processor coupled to a memory (and optionally a graphical user interface (GUI)), the memory having recorded thereon a computer program comprising instructions for performing the method. The memory may also store a database. The memory is any hardware adapted for such storage, possibly comprising several physical distinct parts (e.g. one for the program, and possibly one for the database).

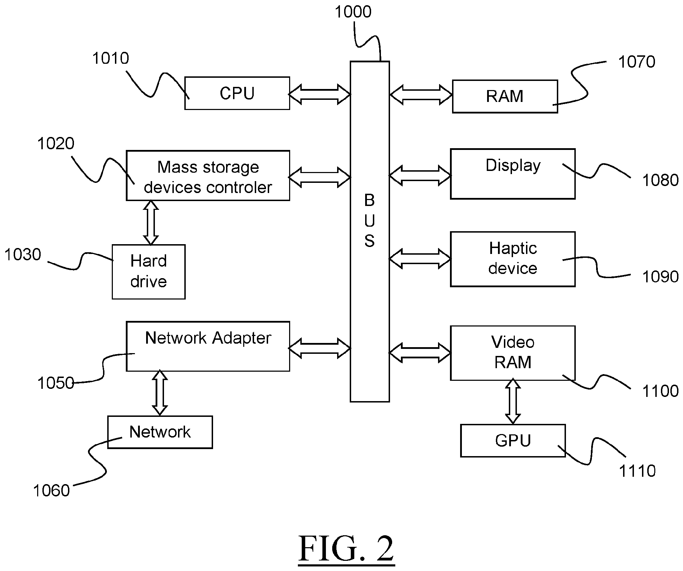

FIG. 2 shows an example of the system, wherein the system is a client computer system, e.g. a workstation of a user.

The client computer of the example comprises a central processing unit (CPU) 2010 connected to an internal communication BUS 2000, a random access memory (RAM) 2070 also connected to the BUS. The client computer is further provided with a graphical processing unit (GPU) 2110 which is associated with a video random access memory 2100 connected to the BUS. Video RAM 2100 is also known in the art as frame buffer. A mass storage device controller 2020 manages accesses to a mass memory device, such as hard drive 2030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 2050 manages accesses to a network 2060. The client computer may also include a haptic device 2090 such as cursor control device, a keyboard or the like. A cursor control device is used in the client computer to permit the user to selectively position a cursor at any desired location on display 2080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

The method is of machine-learning (also called "training method") for assembling mechanical parts. In other words, the training method leverages from machine learning to provide a solution to assembling mechanical parts. The assembly is based on the mating score and the mating axis for the pair of B-Reps . In other words, the mating score and the mating axis serve as criteria for determining the assembly of the mechanical parts.

As known per se from the field of machine-learning, the processing of an input by a neural network includes applying operations to the input, the operations being defined by data including weight values. Training a neural network thus includes determining values of the weights based on a dataset (configured for such training), such a dataset being possibly referred to as a learning dataset or a training dataset. For that, the dataset includes data pieces each forming a respective training sample. The training samples represent the diversity of the situations where the neural network is to be used after being trained. The dataset may comprise a number of training samples higher than 100, 1000, 10000, or more (e.g., 25000), or 100000 or more.

The training method comprises providing S10 the dataset. Providing S10 the dataset may comprise obtaining such a dataset from a data storage medium and/or downloading it from a remote location. Providing S10 the dataset may alternatively comprise creating the dataset, which may include annotating B-Reps, as further discussed hereinafter.

Such a dataset is of pairs of Boundary Representations (B-Reps). Any B-Rep described herein represents a mechanical part. Specifically, the B-Rep is a persistent data representation of the mechanical part. The B-Rep may be the result of computations and/or a series of operations carried out during a designing phase of the represented mechanical part. The shape of the mechanical part displayed on the screen of the computer when the modeled object is represented may be (e.g. a tessellation of) the B-Rep. Each pair is labelled with mating compatibility data and mating axis compatibility data. In other words, a respective pair of B-Reps is associated, in the dataset, to data corresponding to the mating compatibility data and the mating axis compatibility data.

A B-Rep includes entities such as topological entities and geometrical entities. Topological entities (also called B-Rep entities in the present disclosure) are: face, edge, and vertex. Geometrical entities are 3D objects: surface, curve point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open if it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. Indeed, this is because the representation contains surfaces based only on parameters. In other representations such as meshes, the equivalent surface comprises up to thousands of triangles. Moreover, this is also because a B-Rep doesn't contain any history-based information.

The B-Rep may also be represented by a B-Rep graph. Such a graph represents both the geometry and the topology of a B-Rep, as it comprises graph nodes representing the elements of the B-Rep (such as B-Rep entities) and graph edges representing the topological relationships between the elements represented by the nodes connected by the graph edges. In examples, each graph node may represent a respective edge, a respective face. This means that for each edge of the B-Rep, there is a respective graph node, for each face of the B-Rep, there is a respective graph node. In other examples, a B-Rep graph may comprise graph nodes which only represent respective faces and the edges of the B-Rep. Alternatively, a B-Rep graph may comprise graph nodes which only represent respective edges of the B-Rep. Each graph node may further comprise a geometrical and/or topological feature associated with (i.e., attached to) the graph nodes. The feature is data, for example a vector (also referred to as feature vector), associated with the node and describing geometrical data and/or topological data characterizing the B-Rep element represented by the graph nodes.

A B-Rep may be converted into a B-Rep graph or by loading the parts of said B-Rep using a CAD backend and extracting the relevant features. For example, the conversion into a B-Rep graph may comprise mapping the B-Rep edges and faces (that is, topological entities) into graph nodes (i.e., graph vertices), and mapping the adjacency of said topological entities into graph edges. Vertex features encode the geometrical properties of a corresponding entity. In other example, the conversion may also include passing additional adjacency matrices indicating the neighboring entities of each type of topological entity. One widely used open format to represent a B-Rep is the STEP data format. It has an ASCII structure and is therefore easy to read.

The B-Rep may represent the geometry of the mechanical part or assembly of parts (or equivalently an assembly of parts, as the assembly of parts may be seen as a part itself from the point of view of the methods, or the methods may be applied independently to each part of the assembly), or more generally any rigid body assembly (e.g. a mobile mechanism). The B-Rep may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

The mating compatibility data represents an extent of mating compatibility between the mechanical parts represented by the pair. By "mating compatibility" it is meant any indicator (e.g., a value) on the extent by which the mechanical parts represented by both B-Reps may be mated (i.e., assembled) together. The mating compatibility data may thus have a value that indicates if the mechanical parts represented by both B-Reps can be mated together, for example of one if said parts may be mated or zero if these cannot be mated. The mating compatibility data may also comprise intermediate values between zero and one. For example, a mating compatibility data that comprises a value of zero may represent no mating compatibility between both mechanical parts represented by the pair, while a value of one may represent that the mechanical parts represented by the pair of B-Reps are fully compatible to be mated together. It is to be understood that the values above are examples, and other values or ranges may be used (for example 0 and 10 instead of 0 and 1, or the range [0, 10] instead of [0,1]). In examples, the mating compatibility data may have a higher mating compatibility values (closer to 1) to the pair of B-Reps that can be mated with constraints that reduces by a lot the degrees of freedom (e.g. a cylindrical constraint, or a slider constraint), and a lower compatibility value to the pairs of parts that can be mated with constraints that still allow a lot of freedom in motion (e.g. planar constraint).

The mating axis compatibility data represents an extent of compatibility between the mechanical parts represented by the pair along the mating axis defined by a pair of B-Rep entities of the B-Reps of the pair. By "mating axis compatibility" it is meant any indicator on the extent by which the mechanical parts represented by both B-Reps may be aligned along a same mating axis, e.g., in a coordinate frame. The mating axis is relative to the pair of B-Rep entities (e.g., topological entities and/or geometrical entities, as defined above, such as faces, edges and vertices) of the respective B-Reps of the pair. The mating axis may define an origin and an axis vector for the coordinate frame indicating the direction and orientation according to which the parts represented by the B-Reps of the pair are to be mated. The mating axis may for example follow physical constraints on how the mechanical parts represented by the pair should be assembled. The mating axis compatibility data may comprise a respective axis for each B-Rep entity of a corresponding B-Rep of the pair. The mating axis compatibility data may comprise an indicator on a respective axis for each B-Rep entity, for example a respective origin point defined for each B-Rep entity and a respective direction vector (e.g., a normal vector) for each B-Rep entity. The mating axis is the one where, for each B-Rep entity, the respective pair of axes (that is, the respective axis of the two entities) can be aligned with the mating axis when the respective B-Reps are mated together. The respective origin point and the respective direction vector may be defined according to the physical constraints on how the mechanical parts represented by the pair should be assembled.

For example, any B-Rep entity herein/in the present disclosure having a shape of a plane surface, the respective origin point may be a centroid of the plane surface and the respective direction vector may be a normal with respect to the plane. For a B-Rep entity having a shape of a cylinder surface, the respective origin point may be an origin (e.g., located at a central axis of the cylinder) in a coordinate system (e.g., in cartesian coordinates) and the respective direction vector may be an axis direction in a torsional direction (for example normal to the base of the cylinder). For a B-Rep entity having a shape of a cone surface, the respective origin point may be an origin in a coordinate system (e.g., located at the center of the base of the cone surface) and the respective direction vector may be an axis direction in a torsional direction (e.g., normal to the base of the cone). For a B-Rep entity having a shape of a sphere surface the respective origin point may be an origin located at the center of the sphere and the respective direction vector may be rotational axis, e.g., a z-axis direction in cartesian coordinates (with respect to the origin). For a B-Rep entity having a shape of a torus surface, the respective origin point may be an origin located at the center of the torus and the respective direction vector may be orientated on a rotational direction of the torus (e.g., with respect to the origin, for example the axis of revolution of the torus). For a B-Rep entity having a shape of an elliptical cylinder surface, the respective origin point may be an origin in a coordinate system (e.g., located at a central axis of the cylinder) and the respective direction vector may be an axis direction vector in a torsional direction (for example normal to the base of the surface). For a B-Rep entity having a shape of an elliptical cone surface, the respective origin point may be an origin in a coordinate system (e.g., located at the center of the base of the elliptical cone surface) and the respective direction vector may be an axis direction vector in a torsional direction (e.g., normal to the base of the cone). For a B-Rep entity having a shape of a line curve, the respective origin point may be a start point (e.g., an extremity of the line or any other point in the line) and the respective direction vector may be a line parallel to the line. For a B-Rep entity having a shape of an arc curve, the respective origin point may be the center of the arc and the respective direction vector may be normal with respect to the arc. For a B-Rep entity having a shape of a circle curve, the respective origin point may be the center of the arc of the circle and the respective direction vector may be normal with respect to the arc. For a B-Rep entity having a shape of an ellipse curve, the respective origin point may be the center of the arc of the ellipse curve and the respective direction vector may be normal with respect to the ellipse curve. For a B-Rep entity having a shape of an elliptical curve, the respective origin point may be the center of the arc of the elliptical curve and the respective direction vector may be normal vector with respect to the elliptical curve.

Providing S10 the dataset may comprise annotating the pairs of B-Reps with the mating compatibility data and/or the mating axis compatibility data. For example, providing S10 the dataset may comprise obtaining pairs of B-Reps (representing, for example, mechanical parts) from a preexisting dataset (without previous mating compatibility data and/or the mating axis compatibility data).

For a given pair of B-Reps in the pre-existing dataset, the annotating may comprise labeling positively (i.e., creating mating compatibility data having a value of one or above a predetermined threshold) said pair if said pair has been mated together at least one time together in the pre-existing dataset. The annotating may alternatively comprise labeling negatively said pair (i.e., creating mating compatibility data having a value of zero or below a predetermined threshold), by randomly select two parts in the pre-existing dataset which have not been mated together in an assembly. The dataset may thus comprise negatively labeled pairs in addition to positively labelled ones. This improves robustness of the training. For pairs of B-Reps which are labeled positively, the annotating may further include adding information on the mating axis compatibility data, e.g., a mating axis defining an origin and axis vectors for the coordinate frame indicating direction and orientation according to which the B-Reps of the pair are to be mated.

The dataset comprises pairs of B-Reps labelled with mating compatibility data. A subset of the pair of B-Reps may be labelled with mating compatibility data comprising information indicating that such pair of B-Reps cannot be mated together. In other words, such a subset of pairs of B-Reps is of "negative" pairs that cannot be mated together along any axis. The dataset may also comprise a subset of B-Reps labelled with mating compatibility data comprising information indicating that the pair can be mated together. In such a case, the B-Reps of the pair are compatible according to the mating compatibility data. Such subset of B-Reps is also labelled with the mating axis compatibility data. In other words, such a subset of pairs of B-Reps is of "positive" pairs. The training method may obtain any proportion of subsets of negative or positive pairs of B-Reps so as to allow an accurate learning of pairs that can be mated together.

The training method comprises training the neural network based on the dataset. The neural network is a function comprising a collection of connected nodes, also called "neurons". Each neuron receives an input and outputs a result to other neurons connected to it. The neurons and the connections linking each of them have weights, which are adjusted via a training. In the context of the present disclosure, by "training a neural network based on a dataset", it is meant that the dataset is a learning/training dataset of the neural network, based on which the values of the weights neural network are set. In other words, training determines values of the weights of the neural network based on the variability of the pairs of B-Reps labelled with mating compatibility data and with mating axis compatibility data (if such data is present if the B-Reps of the pair are compatible according to the mating compatibility data), as represented by the samples comprised in the provided dataset.

The training may be a supervised training. The training method may set part of the data of the dataset to be used as ground truth data. The dataset is thus used for training the neural network in supervised mode. As known from the field of machine learning, the neural network may thus compare the output with the ground truth data, the weights of the neural network may be adjusted by the training so that the output of the neural network is consistent with the ground truth data.

The neural network is configured for taking as input a pair of B-Reps representing mechanical parts or an assembly of mechanical parts. The pair of B-Reps may be taken as input in any manner. In examples, the neural network may take as input a B-Rep graph representation of each B-Rep of the pair (that is, the neural network takes as input both graphs of both B-Reps). In other words, the neural network may take as input, for each B-Rep of the pair, a graph representation of the B-Reps. The graph representation may represent the topological relationships between the elements represented by the graph nodes connected by the graph edges.

The neural network is configured for outputting a mating score of a pair of single embeddings. The mating score represents a score of mating compatibility between the mechanical parts represented by the pair. The score may be a (e.g., non-negative) value representative of the mating compatibility between the mechanical parts represented by the pair of single embeddings. In other words, the mating score, output by the training method, is a value representative of the extent by which the mechanical parts represented by both single embeddings may be assembled together. The mating score may take a value of one if said parts may be mated or zero if these cannot be mated. The mating score may also have take values between zero and one, thereby indicating the relative mating compatibility of the two parts. For example, the mating score may have a value above a predetermined threshold. Pairs having a mating score above the predetermined threshold may be considered as compatible to be mated from the point of view of the method. It is to be understood that the values above are examples, and other values or ranges may be used (for example 0 and 10 instead of 0 and 1, or the range [0, 10] instead of [0, 1]). Each single embedding represents a B-Rep of the pair. A single embedding of a B-Rep is a vector representation of the B-Rep encoded by the neural network, as known per se from machine-learning and, as the single embedding represents the B-Rep, captures the topology and the geometry of the B-Rep.

The neural network is also configured for outputting data defining the mating axis. The data defining the mating axis may comprise any indicator of a reference frame for at least one B-Rep entity (e.g., all B-Rep entities) of each respective B-Rep of the pair, for example data comprising an origin and a direction vector indicating direction and orientation according to which the parts represented by the B-Reps of the pair are to be mated. The data defining the mating axis may comprise data indicating the direction and orientation according to which the parts represented by the B-Reps of the pair are to be mated. The mating axis may for example follow physical constraints on how the mechanical parts represented by the pair should be assembled. For example, the data may comprise, for each B-Rep entity, an axis on each B-Rep entity (e.g., defined by an origin point and direction axes for each B-Rep entity) and data indicating how the B-Rep entities are assembled along the two axes, e.g., a measure of collinearity between axes when the first B-Rep entity and the second B-Rep entity are mated together along the mating axis. For example, if both axis are colinear (or substantially colinear) these two axes may define a unique (common) mating axis. For example, the first B-Rep of the pair may comprise a first B-Rep entity having a shape of a torus surface. The second entity may comprise a second B-Rep entity having a shape of a cylinder surface. The data may comprise, for the first B-Rep of the pair, a first axis defining an origin located at the center of the torus and a respective direction vector orientated on a rotational direction. The data also comprises, for the second B-Rep of the pair, a second axis defining an origin located at a central axis of the cylinder and an axis direction vector in the normal direction to the base of the cylinder. The data may comprise data indicating that the first axis and the second axis are colinear, thereby indicating that the first B-Rep entity and the second B-Rep entity are compatible to be mated together.

As the training determines values of the weights of the neural network based on the dataset, the neural network leverages from the geometry of the B-Reps and the accompanying mating compatibility data and/or the mating axis compatibility data (if such data is present if the B-Reps of the pair are compatible according to the mating compatibility data) for outputting the mating score and the data defining the mating axis (if the B-Reps of the pair are compatible according to the mating score). In other words, the output mating score is dependent on the values of the weights of the neural network which have been set by the training. Indeed, as the neural network is trained with pairs of B-Reps labeled with the mating compatibility data and the mating axis compatibility data, mating score is consistent with the values of extent of mating compatibility and the mating axis compatibility as captured in the training dataset. This allows to implement a supervised training, where the pairs of B-Reps labeled with the mating compatibility data and the mating axis compatibility data form ground truth data that the neural network is trained to respect when predicting mating score. The weights of the neural network are thereby adjusted by the training so that the output of the neural network (i.e., the mating score and the data defining the mating axis) is consistent with the ground truth data (i.e., the value comprised by the mating compatibility data and the mating axis compatibility data).

The training method thus improves machine-learning for assembling mechanical parts. Indeed, the mating score of the pair of single embeddings altogether with the data defining a mating axis provide an objective indicator of the extent by which the mechanical parts represented by the pair may be mated along corresponding parts of the mechanical part (as represented by corresponding pairs of B-Rep entities of the B-Reps of the pair). In other words, the neural network trained with the training method outputs an indicator of the mating compatibility of the mechanical parts along the mating axis defined by the pair of B-Reps, which effectively indicates the mechanical efficiency of the mechanical parts corresponding to the pair of B-Reps when assembled. Thus, mechanical parts that have a high compatibility (in terms of the mating score along with the data defining the mating axis) are ensured to be assembled together in a manner that respects mechanical constraints, and thus the designer obtains a realistic and efficient assembly from a mechanical point of view. Indeed, thanks to the neural network taking into account the mating score and the data defining the mating axis, the neural network enables the designer to obtain an assembly of mechanical parts that has improved mechanical properties thanks to the mechanical parts being effectively mated.

The neural network may comprise an embedding network. The embedding network is configured to be applied to a respective pair of B-Reps and to output a single embedding for each B-Rep of the pair. The embedding network may be a neural network configured to (i.e. trained to) determine a mapping (also called encoding) between the original input space of the dataset (i.e., a space of B-Reps) and a low-dimensional space known as the embedding space or latent space. The embedding network is configured to output a single embedding for each B-Rep of the pair. The single embedding may be a vector representing B-Rep entities such as faces and/or edges of each B-Rep of the pair. In other words, the neural network encoder outputs one single embedding for each input B-Rep representing the B-Rep entities.

By single embedding it is meant any data, such as a (multi-dimensional) vector having values that are representative of B-Rep entities of a B-Rep of the pair, for example, faces and/or edges of the B-Rep. In other words, the single embedding may be any data such that it allows the discrimination of the faces and/or edges of a B-Rep of the pair.

The neural network may also comprise a mating compatibility score network.

The mating compatibility score network may be a deep neural network model configured to output the mating score based on its input. The score neural network is configured to take as input a concatenation of the pair of single embeddings and output the mating score. In other words, the score neural network is configured to take as input concatenated single embeddings and outputs the mating score, i.e., a vector regrouping the two vectors each representing a respective single embedding.

The neural network may also comprise an axis network. The axis network is configured to be applied to a respective pair of B-Reps. The axis network is configured to output data defining a mating axis of the pair, if the B-Reps of the pair are compatible according to the mating compatibility data. During training, the training method may take the respective pair of B-Reps (labelled with the mating compatibility data and the mating axis compatibility data) and output the output data defining the mating axis. In examples, the method may discard inputting from the dataset B-Reps of the pair that are not labelled with the mating axis compatibility data. In other words, the method skips the training of the axis network on negative pairs. Thus, once trained, the axis network may not be applied to pairs for which the mating score predicted by the mating compatibility score neural network is smaller than a predetermined threshold. The weights of the axis network may be updated according to whether the pair of B-Reps may be mated along the mating axis. Each mating axis being defined on a respective B-Rep entity of a respective B-Rep of the pair. In other words, the training method trains the axis network to infer whether the pair of B-Reps may be mated based on the mating axis compatibility data and to infer the data defining the mating axis. In examples, the inference by the axis network may be a multiclass classification problem (in such a case, the ground truth score may equal one if and only if the B-Reps of the pair are mated along the mating axis) or a binary classification problem (in such a case, the ground truth score may be equal to one if the mating axis is collinear with axes defined on the two B-Reps when the B-Reps are mated). In examples, the axis network may comprise an MLP neural network.

The neural network may also comprise a Siamese encoder. The Siamese encoder is configured to take as input the pair of B-Reps, the output of the Siamese encoder being passed as input to the mating compatibility score network and the axis network.

The Siamese encoder may be a neural network encoder which is applied twice, to each B-Rep of the input pair. In other words, in implementations, at each training iteration, the training method feeds a first B-Rep of the pair to the Siamese encoder, then the training method feeds the second B-Rep of the pair as input.

The Siamese encoder may be configured to take as input the pair of B-Reps. The Siamese encoder may be a graph neural network that takes as input node-level vectorial representations of the B-Reps of the pair. The training method may provide the graph neural network input B-Rep graphs corresponding to the input B-Reps. In examples, the input B-Rep graph may be a hierarchical graph G=(N, E) with a node feature matrix F. The training method may perform any kind of data processing to the input pair of B-Rep to the Siamese encoder so as to obtain the B-Rep graphs, e.g., by applying a STEP parser on to said B-Reps when said B-Reps are in the STEP format.

The output of the Siamese encoder is passed as input to the mating compatibility score and the axis network. To end the training iteration, the training method updates the weights of the Siamese encoder, the mating compatibility score network and the axis network, for example by backpropagation of a loss function, as explained below. In any case, the training method applies the Siamese encoder twice during a single training iteration, but the weights are updated once, at the end of the iteration; so the same weights are applied to both parts by applying the same network twice. In yet other words, the term "Siamese" only indicates that there are two distinct inputs but apply one single network. The weights of the Siamese graph neural network encoder (set in the training) may be applied on graph's nodes and edges of each input B-Rep (listing its B-Rep entities, their geometrical features and/or adjacencies) to compute a respective single embedding. In examples, the training updates the weights of the Siamese encoder by backpropagating the result of a loss after both input B-Reps have been processed. In examples, the output of the Siamese encoder may be high-dimensional node-level embeddings. The node-level embeddings may have information of respective nodes of the B-Rep graph representation of the input B-Reps and their surroundings (e.g., neighbor faces and/or vertices sharing respective nodes). In examples, the output of the Siamese encoder may be an entity-level embedding matrix V.

The neural network may also comprise a pooling module. The pooling module may be learnable (i.e., trainable with the training method) or have been pre-trained (in such a case, the weights of the pooling module being set). The pooling module may be applied on the output of the Siamese encoder. In other words, the pooling module takes as input the single embeddings of the pair of input B-Reps output by the Siamese encoder. The pooling module may comprise pooling layers which down sample the output of the Siamese encoder. In examples, the pooling module may comprise concatenating the single embeddings and applying a graph pooling layer on the concatenation. The graph pooling layer may comprise a Max Pooling layer and/or an Average Pooling layer. In examples, the pooling module may take as input an entity-level matrix V (representing an arrangement of single embeddings of B-Rep entities of the single B-Reps) output by the Siamese encoder and output a global embedding vector $V_{glob}$.

This results in an improved accuracy and efficiency for the determination of mating compatibility, as use of the pooling module ensures that the output of the Siamese encoder is a low dimensional representation. Thereby, the memory requirements are significantly reduced.

The embedding network, the mating compatibility score network and the axis network may be trained simultaneously using a loss.

By "trained simultaneously" it is meant that the training method adjusts the weights of the embedding network, the mating compatibility score network and the axis network at the same time (i.e., in a same training process) with the loss. In examples, the embedding network may comprise (e.g., consist of) the Siamese encoder, the axis network may comprise (e.g., consist of) the MLP neural network and the loss may adjust simultaneously the weights of the Siamese encoder and the MLP neural network along with the weights of the score neural network. For example, the loss may output values (e.g., indicative of agreement of mating compatibility and/or the mating axis compatibility) and backpropagate the values to adjust the weights of the Siamese encoder, the axis network and the score neural network.

The loss may penalize, for each pair of B-Reps of the dataset, a disparity between the mating compatibility data of the pair of B-Reps and the mating score output by the neural network for the pair of B-Reps.

In examples, the loss may penalize the disparity between the mating compatibility data of the pair of B-Reps and the mating score outputted by the neural network for the pair of B-Reps with a binary cross-entropy loss. In other words, the training method trains the neural network to infer the mating compatibility between the B-Reps of a pair of B-Reps as a binary classification problem by penalizing the disparity with the binary cross-entropy loss. The binary cross-entropy loss may be of the form:

$$BCE = -\frac{1}{N}\sum_{i=0}^{N}(y_i \cdot \log(\widehat{y_i}) + (1 - y_i) \cdot \log(1 - \widehat{y_i}))$$

The result of the inference (that is, the output by the loss) output by the binary cross-entropy loss BCE may be a probability score between 0 and 1, where 0 means that the pair of B-Reps use at training cannot be mated and 1 means that the pair can be mated. N denotes the total number of pairs, $y_i$ denotes a ground truth score and $\widehat{y_i}$ denotes the prediction.

Additionally or alternatively, the loss may penalize, for each pair of B-Reps of the dataset, a disparity between the mating axis compatibility data of the pair of B-Reps and the data defining the mating axis output by the neural network for the pair.

In examples, the method may skip the training of the mating axis network for pairs of B-Reps of the dataset that are not compatible according to the mating compatibility data. This improves the efficiency of the training as the complexity of the mating axis network may grow exponentially as the size of the mechanical assembly represented by the B-Reps increases and so skipping the training on pairs that cannot be mated together allows to improve the overall time needed for training.

The loss may penalize the disparity between the mating axis compatibility data of the pair of B-Reps and the data defining the mating axis outputted by the neural network for the pair with a binary cross-entropy loss as above. The result of the inference (that is, the output by the loss) output by the binary cross-entropy loss BCE may be a probability score between 0 and 1, where 1 means that the pair of axes is collinear with the pair of axes along which the two objects are mated.

Alternatively, the loss may penalize the disparity between the mating axis compatibility data of the pair of B-Reps and the data defining the mating axis outputted by the neural network for the pair with a mean-squared error (MSE) loss. In other words, the training method trains the neural network with the loss to infer the mating axis data (on the pairs of B-Reps that are compatible according to the mating compatibility data) as a multiclass classification problem, where the ground truth score equals one if and only if the two objects can be mated along this pair of axes. The mean square loss may be of the form:

$$MSE = \frac{1}{N}\sum_{i=1}^{N}(y_i - \widehat{y_i})^2$$

where y is the ground truth score, N is the total number of pairs and y is the prediction (i.e., 1 if the object can be mated or 0 if it cannot be mated).

This further improves the machine-learning or assembling mechanical parts. Indeed, the loss optimizes the inference of pairs that may be mated together and, when the loss penalizes the disparity between the mating axis compatibility data of the pair of B-Reps and the data defining the mating axis outputted by the neural network for the pair, the loss optimizes the inference of mating axis for a pair of B-Reps that can be mated; in other words, the loss optimizes pairs of B-Reps that can be mated along the mating axis.

Examples of the methods of the present disclosure are now discussed with reference to FIG.s 3 to 6.

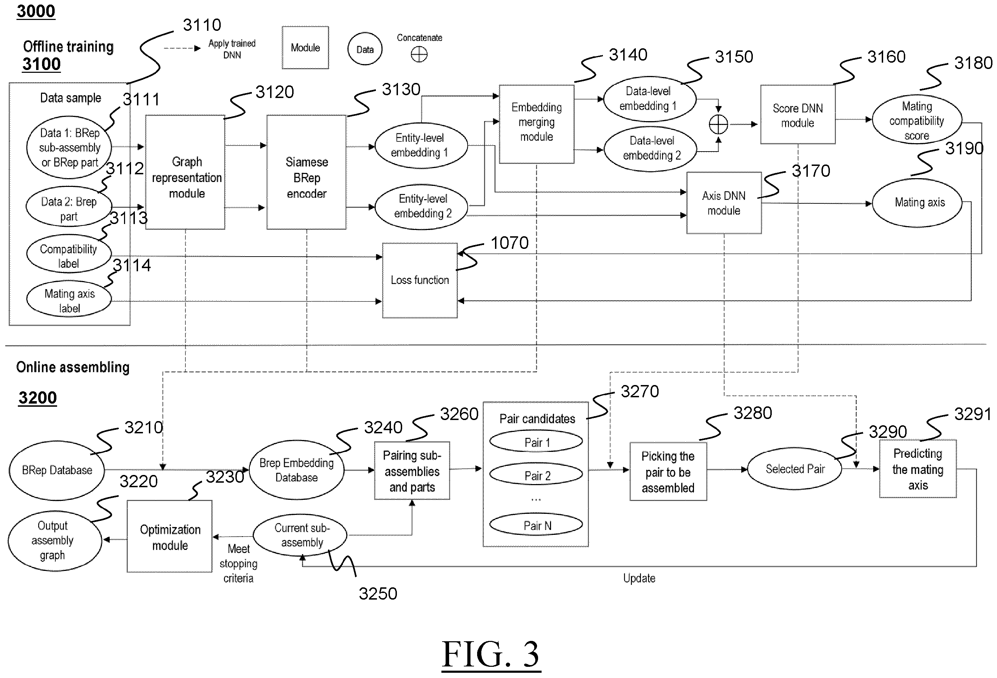

The implementation relates to a learning-based framework 3000 to perform automatic generation of assembly graphs of 3D mechanical assemblies from a set of CAD parts. The CAD parts are represented by Boundary Representations (B-Reps). Reference is made to FIG. 3, illustrating the learning-based framework divided in a training stage 3100 (also denoted "offline training") and an online stage (also denoted "online assembling"). The training stage of the framework is based on deep learning techniques, that is on the training method. The training step is performed on a training dataset that contains B-Rep assemblies. The online stage of the framework is based on the method of use.

The training stage 3100 is now discussed.

The training stage 3100 comprises a provided dataset 3110 of training samples. The training samples are of pairs of B-Reps 3111, 3112 representing mechanical parts. The pair 3111 3112 is labelled with mating compatibility data 3113 and mating axis compatibility data 3114.

The training stage 3100 also comprises a graph representation module 3120 that pre-process the pair of B-Reps 3111, 3112 as graphs, as it will be discussed below.

The neural network comprises:

    i. A Siamese B-Rep encoder 3130 that takes as input the pair of B-Reps 3111, 3112 in graph representation and outputs an entity-level embedding matrix;
    ii. An embedding merging module 3140 that takes as input an entity-level embedding matrix and outputs a data-level embedding 3150 which concludes the topological and geometric information of the input B-Rep data;
iii. A score DNN module 3160 that takes as input a pair of data-level embeddings and outputs a compatibility score;
iv. An axis DNN module 3170 that takes as input a pair of entity-level embedding matrices and outputs a mating axis with which the two input data are aligned.

The training is end-to-end: a loss module computes both the compatibility score loss and the mating axis loss, and then backpropagates the errors to adjust the weights of the learnable modules.

The neural network outputs a mating score 3180 and data 3190 defining mating axis.

The training method may also comprise, at the training stage, the following subtasks prior to the training:

a. Annotating the dataset 3110: The training method may obtain the dataset 3110 from a database containing raw 3D mechanical assemblies, that is B-Reps representing mechanical parts without labels. Pairs containing a sub-assembly/part and a single part are sampled from the database. The training method may generate both positive pairs (i.e. mateable pairs) and negative pairs (i.e. unmateable pairs) to perform the training. The training method may generate ground-truth labels during the sampling. Examples of annotations will be given below.

b. Data preprocessing of the B-Rep pairs 3111,3112 with a graph representation module 3120: The B-Rep parts and B-Rep assemblies are represented as graphs in order to be processed by the neural network.

c. Design of the neural network, comprising the Siamese B-Rep encoder 3130, Embedding merging module 3140, Score DNN module 3160 and Axis DNN module 3170, as illustrated above.

d. Design of the losses: The loss function 3170 should optimizes the distance between the predicted score and the ground-truth score for all pairs and the distance between the predicted mating axis and the ground-truth mating axis for positive pairs.

e. Training strategy: The training method performs the training on the dataset for complex 3D mechanical assemblies.

The online stage 3200 is now discussed.

The online stage 3200 aims at generating assembly proposals from a B-Rep database 3210. The B-Rep parts are encoded into data-level embeddings using the trained B-Rep encoder 3120 and Embedding-merging module.

Starting from an arbitrary part of the B-Rep database 3210 as current sub-assembly, the online stage may follows an iterative process. The iterative process may be performed until there is no part left in the database or until the current sub-assembly satisfies a certain user-defined criteria.

The iterative process may comprise:

I. Pairing the current sub-assembly with the rest parts in the database and compute the compatibility using the trained score DNN module 3160. Select among the top K pairs the part to be mated.

II. Computing the mating axis using the trained axis DNN module 3190 for the current sub-assembly and the part to be mated.

III. Updating the current sub-assembly and the B-Rep database.

The iterative process may output multiple proposals for user to choose, and an optional optimization module can be applied to generate a 3D assembly with valid mating from a 3D assembly graph.

An example for providing the dataset 3110 is now discussed.

To train a Siamese neural network, the method generates a set of positive pairs and a set of negative pairs. "Positive" means that the pair of CAD parts/sub-assemblies is mateable along a certain mating axis and "negative" means that the pair is not mateable along any mating axis.

To generate the data, the training method uses a dataset containing CAD assemblies with the following information for each assembly: (1) the B-Rep model of every involved parts and (2) the mating axis of every pair of mated parts.

Given such dataset, the training method takes one assembly and generate at first its part-level assembly graph, i.e. a graph with nodes being involved parts and edges connecting every pairs of mated parts. The training method extracts a subgraph (that is, a connected graph with fewer nodes than the assembly graph) as a subassembly and pair it with another connected part if we need a positive pair, or another disconnected part if we need a negative pair.

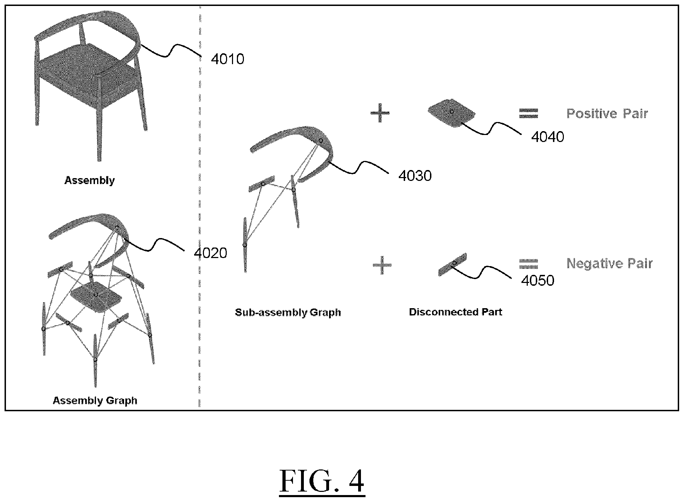

FIG. 4 illustrates an example of pair of B-Reps of the dataset.

The assembly 4010 may be used for generating the assembly graph 4020. The pair may comprise a first part 4030 and a second part 4040. In such a case the pair is a positive pair because these can be mated. The first part 4030 and the other part 4050 are a negative pair, as the pair cannot be mated.

The training method may take into account the following implementation parameters for generating the data:

• The size of the sub-assemblies,

- The total number of the generated pairs,
- The balance of the positive vs. negative pairs in the training set.

Data pre-processing for the training is now discussed.

The data preprocessing is dependent on the architecture of the B-Rep encoder.

The method constructs, for a single B-Rep, an entity-level graph with nodes being the topological entities (i.e. faces / edges / co-edges / vertices) and edges representing the topological connectivity. The nodes are assigned to a feature vector describing both its geometric features (e.g. edge length, face area, etc.) and topological features (e.g. edge type, face type, etc.).

To extend the graph representation to sub-assemblies, the method uses a hierarchical graph that assembles the entity-level assembly graphs by connecting the two entity-level nodes where a pair of parts is mated.

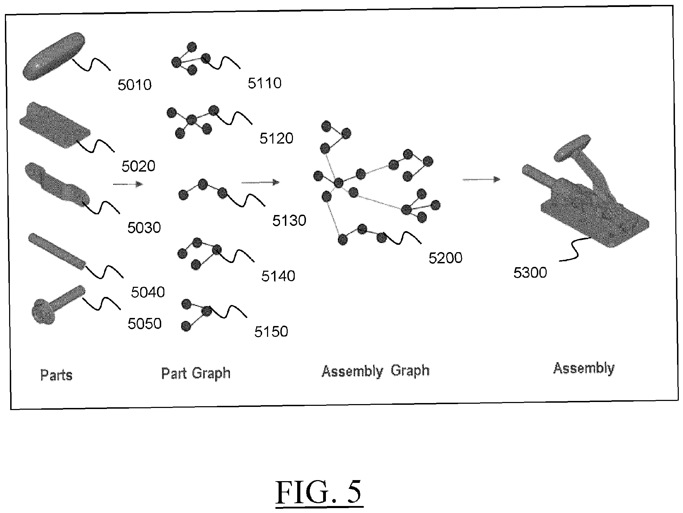

FIG. 5 illustrates an example of graph representations. The B-Reps (also called parts) 5010-5050 are represented by B-Rep graphs (also called part graphs) 5110-5150. The B-Rep graphs may be assembled (as an output of the trained neural network) as an assembly graph 5200, e.g., by establishing edges connecting the B-Rep graphs. The assembly may be represented as a B-Rep 5300.

The design of the neural network is now discussed.

The framework offers a high flexibility regarding the design of the deep learning architecture used with the training method. Table I below lists the input and the output of each component and details the choices.

Table I

| Component | Input | Output |
|---|---|---|
| B-Rep encoder | A hierarchical graph $G=(N, E)$ and its node feature matrix $F$ | Learnt entity-level embedding matrix $V$ |
| Embedding merging module | Entity-level embedding matrix $V$ | A global embedding vector $V_{glob}$ |
| Score DNN module | A pair of global embedding vectors | Score prediction depending on the choice of training loss |
| Axis DNN module | A pair of entity-level embedding vectors | Axis prediction depending on the choice of training loss |

The B-Rep encoder may be any graph neural network that learns node-level vectorial representations for CAD objects in B-Rep format. The recent proposed networks, including UV-Net (as disclosed in Jayaraman, Pradeep Kumar, Aditya Sanghi, Joseph G. Lambourne, Karl DD Willis, Thomas Davies, Hooman Shayani, and Nigel Morris. "Uv-net: Learning from boundary representations." In Proceedings of the IEEE/CVF conference on computer vision and pattern recognition, pp. 11703-11712. 2021.), B-RepNet (as disclosed in Lambourne, Joseph G., Karl DD Willis, Pradeep Kumar Jayaraman, Aditya Sanghi, Peter Meltzer, and Hooman Shayani. "B-repnet: A topological message passing system for solid models." In Proceedings of the IEEE/CVF conference on computer vision and pattern recognition, pp. 12773-12782. 2021), SB-GCN (as disclosed in Jones, Benjamin, Dalton Hildreth, Duowen Chen, Ilya Baran, Vladimir G. Kim, and Adriana Schulz. "Automate: A dataset and learning approach for automatic mating of cad assemblies." ACM Transactions on Graphics (TOG) 40, no. 6 (2021): 1-18), JoinABLe(as disclosed in Willis, Karl DD, Pradeep Kumar Jayaraman, Hang Chu, Yunsheng Tian, Yifei Li, Daniele Grandi, Aditya Sanghi et al. "Joinable: Learning bottom-up assembly of parametric cad joints." In Proceedings of the IEEE/CVF Conference on Computer Vision and Pattern Recognition, pp. 15849-15860. 2022), may be used. The network takes graphs with initialized features as input and produces high-dimensional node-level embeddings containing both the information of a node and its surroundings.

The embedding merging module may be a layer or a block with or without learnable parameters depending on the dataset scale. If a small dataset is used, we can consider a graph pooling layer without learnable parameters, like Max Pooling, Average Pooling. If a large dataset is used, we can consider a transformer based block followed by a pooling layer.

The score DNN module may be an MLP (multilayer perceptron) that takes the global embedding vectors of two objects and predicts if the two objects can be mated or not. Architectures that are more complicated can be considered if there are enough training data.

The axis DNN module may be an MLP (multilayer perceptron) that takes the local embedding vectors of a pair of entities from two objects and predict if these objects are mateable along the given entity axes. Architectures that are more complicated can be considered if there are enough training data.

The loss is now discussed.

The training loss measures the distance between the prediction and the ground truth thus decides the optimization objectives of the neural network. The design of the losses influences both data annotation and training strategy.

In this example, the training method uses two losses. The first loss is for optimizing the inference of compatibility scores. The second loss is for optimizing the inference of the mating axis for a pair of mateable objects (part / sub-assembly).

Loss for optimizing the inference of the compatibility score: the inference of compatibility between a pair of objects can be considered as a binary classification problem. In this case, the result of the inference is a probability score between 0 and 1, and it can be optimized using binary cross entropy loss where y is the ground truth score (i.e. 1 for mateable pairs and 0 for non-mateable pairs), y is the inference and N is the total number of pairs:

$$BCE = -\frac{1}{N}\sum_{i=0}^{N}(y_i \cdot \log(\widehat{y_i}) + (1 - y_i) \cdot \log(1 - \widehat{y_i}))$$

Loss for optimizing the inference of the mating axis: the inference of mating axis can be considered as either a multiclass classification problem (where the ground truth score equals to 1 if and only if the two objects are mated along this pair of axes) or a binary classification problem (where the ground truth score equals to 1 if the pair of axes is collinear with the pair of axes along which the two objects are mated). In the case of binary classification problem, the training method adapts the above mentioned binary cross entropy loss. In the case of multiclass classification problem, the method uses the mean squared error loss, where y is the ground truth score, y^is the inference and N is the total number of pairs:

$$MSE = \frac{1}{N}\sum_{i=1}^{N}(y_i - \widehat{y_i})^2$$

An example of the training is now discussed.

The complexity of the axis DNN module grows exponentially as the size of the assembly increases or the shape of the parts complicates. In order to train the neural network efficiently, the method may skip training the axis DNN module when using negative pairs. For positive pairs, instead of training the axis DNN module on every possible combinations of pairs of entities, the training method may sample the pairs while keeping a good balance between mateable and non-mateable pairs. In the example implementation, the training method took 40 hours for training the neural network based on 230,000 pairs of assemblies.

An example of the online stage is now discussed.

The design of this stage is highly flexible so as to be adapted to multiple application scenarios. In the example implementation, the pipeline takes as input a set of CAD parts to be mated together and starts the assembly from the part containing most entities. One can also start the assembly from the part having the maximum volume or a user-selected part. In each step of assembly, we can either select the part having the highest confidence or select stochastically a part from top-K propositions with respect to their confidence scores. The assembly stops when there is no more mateable part or the maximum number of parts is attained. The inference took 2.5 seconds in this example.

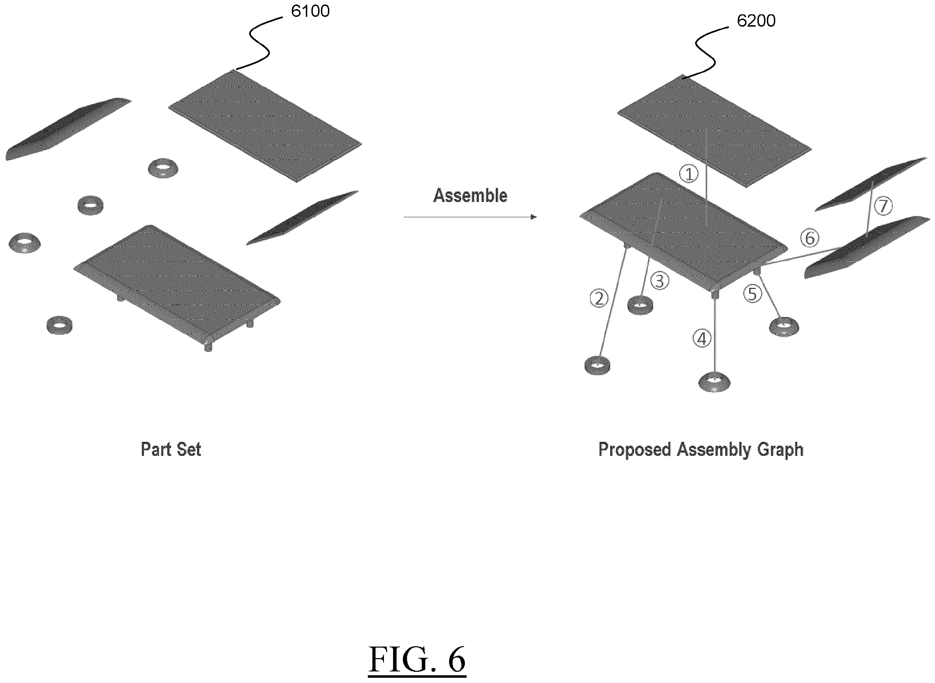

FIG. 6 illustrates an example of B-Reps 6100 input to the neural network and an assembly 6200 output by the method of use.

The training method results in that each input (part or sub-assembly) is encoded into a single embedding vector while taking into account the embedding of each of its faces, edges and their neighborhood. Moreover, the neural network infers a compatibility score between each pair of the inputs. The neural network also infers the mating axis of each pair, for example from the Top-K pairs with the highest score.

Each pair is then mated based on the predicted mating axis to create the graph assembly. The process is iterative until mating all the pairs of parts or sub-assemblies having a mating compatibility score above a predetermined threshold.

The neural network is trained on well-annotated datasets.

In addition, the training method achieves automation and time efficiency: the training method allows for fast generation of 3D assembly graphs from a set of 3D parts represented as B-Reps.

The method of use is data-driven: indeed, the training method allows leveraging B-Rep assembly datasets on which to learn.

Therefore, efficient automatic generation of 3D assemblies from a set of 3D parts is achieved in view of the manufacturing of the mechanical assembly represented from the 3D assemblies.

**Claims**

1. A computer-implemented method of machine-learning for assembling mechanical parts, based on a mating score and a mating axis, the method comprising:

   - providing (S10) a dataset of pairs of Boundary Representations (B-Reps) representing mechanical parts, each pair comprising at least one B-Rep representing an assembly of mechanical parts, each pair being labelled with mating compatibility data and, if the B-Reps of the pair are compatible according to the mating compatibility data, mating axis compatibility data, the mating compatibility data representing an extent of mating compatibility between the mechanical parts represented by the pair, the mating axis compatibility data representing an extent of compatibility between the mechanical parts represented by the pair along a mating axis defined by a pair of B-Rep entities of the B-Reps of the pair; and
   - training (S20) a neural network based on the dataset, the neural network being configured for taking as input a pair of B-Reps each representing a mechanical part or an assembly of mechanical parts, and for outputting:

      ∘ a mating score of a pair of single embeddings, each single embedding representing a B-Rep of the pair, the mating score representing a score of mating compatibility between the mechanical parts represented by the pair, and
      ∘ if the B-Reps of the pair are compatible according to the mating score, data defining a mating axis.

2. The method of claim 1, the neural network comprising:

   - an embedding network configured to be applied to a respective pair of B-Reps and to output a single embedding for each B-Rep of the pair;
   - a mating compatibility score network configured to take as input a concatenation of the pair of single embeddings and to output the mating score; and
   - an axis network configured to be applied to a respective pair of B-Reps and to output data defining a mating axis of the pair.

3. The method of claim 2, wherein the embedding network comprises a Siamese encoder configured to take as input the pair of B-Reps, the output of the Siamese encoder being passed as input to the mating compatibility score network and the axis network.

4. The method of claim 3, wherein the neural network comprises a pooling module applied on the output of the Siamese encoder.

5. The method of any one of claims 2 to 4, wherein the embedding network, the mating compatibility score network and the axis network are trained simultaneously using a loss, the loss penalizing, for each pair of B-Reps of the dataset:

   - a disparity between the mating compatibility data of the pair of B-Reps and the mating score outputted by the neural network for the pair of B-Reps; and/or
   - a disparity between the mating axis compatibility data of the pair of B-Reps and the data defining the mating axis outputted by the neural network for the pair.

6. A neural network trainable according to any one of claims 1 to 5.

7. A method of use of the neural network of claim 6, the method of use comprising:

   obtaining a set of B-Reps, each B-Rep being associated with a single embedding obtained by applying the neural network to the B-Rep; and
   determining an assembly of parts based on the set, by applying iteratively the neural network to a pair comprising a B-Rep of the set and an assembly resulting from the previous iteration.

8. The method of use of claim 7, the determining being further based on the data defining a mating axis outputted by the neural network.

9. The method of use of claim 7 or 8, further comprising applying an optimization to the assembly, the optimization fixing the degrees of freedom between the parts of the assembly.

10. The method of use of any one of claims 7 to 9, wherein the iterations stop upon reaching a predetermined number of parts and/or all possible compatible parts of the set have been explored.

11. The method of use of claims 7 to 10, wherein the iterations start by the user selecting a B-Rep of the set or the system automatically selecting a B-Rep of the set based on a predetermined criterion.

12. The method of any one of claims 1 to 5 or 7 to 11, further comprising computing the embeddings of the B-Reps of the set by applying the neural network.

13. A computer program comprising instructions which, when the program is executed by a computer, cause the computer to carry out the method of any one of claims 1 to 5 and/or the method of use of any one of claims 7 to 12.

14. A computer readable storage medium having recorded thereon a computer program of claim 13 and/or the neural network of claim 6.

15. A system comprising a processor coupled to a memory, the memory having recorded thereon the computer program of claim 13 and/or the neural network of claim 6.

providing a dataset of pairs of Boundary Representations (B-Reps) representing mechanical parts $\quad$ S10

training a neural network based on the dataset $\quad$ S20

## FIG. 1

1000

1010 CPU

1070 RAM

1020 Mass storage devices controler

1080 Display

1030 Hard drive

B U S

1090 Haptic device

1050 Network Adapter

1100 Video RAM

1060 Network

1110 GPU

## FIG. 2

FIG. 3

FIG. 4

## FIG. 5

**FIG. 6**

Part Set

6100

Assemble

Proposed Assembly Graph

6200

Europäisches Patentamt
European Patent Office
Office européen des brevets

## EUROPEAN SEARCH REPORT

**Application Number**

EP 24 30 6555

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | KARL D D WILLIS ET AL: "JoinABLe: Learning Bottom-up Assembly of Parametric CAD Joints", ARXIV.ORG, CORNELL UNIVERSITY LIBRARY, 201 OLIN LIBRARY CORNELL UNIVERSITY ITHACA, NY 14853, 22 April 2022 (2022-04-22), XP091195871, * Abstract; pages 1-8, sections 1-6; pages 28-30, section A.3; Figures 2, 3, 4, 6, 34 * | 1-15 | INV. G06F30/17 G06F30/27 G06N3/045 G06N3/08 |
| A,D | JONES BENJAMIN ET AL: "AutoMate: A Dataset and Learning Approach for Automatic Mating of CAD Assemblies", ACM TRANSACTIONS ON GRAPHICS, ACM, NY, US, vol. 40, no. 6, 10 December 2021 (2021-12-10), pages 1-18, XP059329739, ISSN: 0730-0301, DOI: 10.1145/3478513.3480562 * Abstract; pages 2-8, sections 1, 3, 4, 5; Figures 1, 4, 5, 9, 13 * | 1-15 | |
| A | CN 116 562 804 A (NANJING UNIVERSITY OF TECHNOLOGY) 8 August 2023 (2023-08-08) * page 1, paragraph 1 - page 8, paragraph 56; figure 2 * | 1-15 | TECHNICAL FIELDS SEARCHED (IPC) G06F G06N |

The present search report has been drawn up for all claims

| Place of search | Date of completion of the search | Examiner |
|---|---|---|
| Munich | 24 January 2025 | Lindner, Anja |

## ANNEX TO THE EUROPEAN SEARCH REPORT
## ON EUROPEAN PATENT APPLICATION NO.

EP 24 30 6555

This annex lists the patent family members relating to the patent documents cited in the above-mentioned European search report.
The members are as contained in the European Patent Office EDP file on
The European Patent Office is in no way liable for these particulars which are merely given for the purpose of information.

24-01-2025

| Patent document cited in search report | Publication date | Patent family member(s) | Publication date |
|---|---|---|---|
| CN 116562804 A | 08-08-2023 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JAYARAMAN ; PRADEEP KUMAR ; ADITYA SANGHI ; JOSEPH G. LAMBOURNE ; KARL DD WILLIS ; THOMAS DAVIES ; HOOMAN SHAYANI ; NIGEL MORRIS**. Uv-net: Learning from boundary representations. *In Proceedings of the IEEE/CVF conference on computer vision and pattern recognition*, 2021, 11703-11712
- **LAMBOURNE, JOSEPH G. ; KARL DD WILLIS ; PRADEEP KUMAR JAYARAMAN ; ADITYA SANGHI ; PETER MELTZER ; HOOMAN SHAYANI.** B-repnet: A topological message passing system for solid models. *Proceedings of the IEEE/CVF conference on computer vision and pattern recognition*, 2021, 12773-12782
- **JONES, BENJAMIN ; DALTON HILDRETH ; DUO-WEN CHEN ; ILYA BARAN ; VLADIMIR G. KIM ; ADRIANA SCHULZ.** Automate: A dataset and learning approach for automatic mating of cad assemblies.. *ACM Transactions on Graphics (TOG)*, 2021, vol. 40 (6), 1-18
- **WILLIS, KARL DD ; PRADEEP KUMAR JAYARAMAN ; HANG CHU ; YUNSHENG TIAN ; YIFEI LI ; DANIELE GRANDI ; ADITYA SANGHI et al.** Joinable: Learning bottom-up assembly of parametric cad joints.. *Proceedings of the IEEE/CVF Conference on Computer Vision and Pattern Recognition*, 2022, 15849-15860